# FASCICULE DE BREVET EUROPEEN

(11) **EP 3 136 429 B1**
(45) Date de publication et mention de la délivrance du brevet: **09.02.2022**
(21) Numéro de dépôt: 16185745.3
(22) Date de dépôt: 25.08.2016
(51) Int. Cl.: H01L 21/8258, H01L 21/285, H01L 21/768, H01L 21/8238

(54) **FORMATION DE CONTACTS OHMIQUES POUR UN DISPOSITIF DOTE D'UNE REGION EN MATERIAU III-V ET D'UNE REGION EN UN AUTRE MATERIAU SEMI-CONDUCTEUR**
HERSTELLUNG VON OHMSCHEN KONTAKTEN FÜR EINE VORRICHTUNG, DIE EINEN BEREICH AUS III-V-HALBLEITERMATERIAL UND EINEN BEREICH AUS EINEM ANDEREN HALBLEITERMATERIAL ENTHÄLT
FORMATION OF OHMIC CONTACTS FOR A DEVICE COMPRISING A REGION MADE OF III-V MATERIAL AND A REGION MADE OF ANOTHER SEMICONDUCTOR MATERIAL

(30) Priorité: 31.08.2015 FR 1558060
(43) Date de publication de la demande: 01.03.2017
(73) Titulaire: Commissariat à l'énergie atomique et aux énergies alternatives, 75015 Paris (FR); STMicroelectronics (Crolles 2) SAS, 38920 Crolles (FR)
(72) Inventeur: RODRIGUEZ, Philippe, 38140 RIVES (FR); GHEGIN, Elodie, 38170 SEYSSINET-PARISET (FR); NEMOUCHI, Fabrice, 38430 MOIRANS (FR)
(74) Mandataire: Brevalex

(56) Documents cités:
- WO-A1-2015/057171
- FR-A1- 3 002 688
- US-A1- 2013 280 907
- US-A1- 2014 307 997

## Description

### DOMAINE TECHNIQUE ET ART ANTÉRIEUR

La présente demande a trait au domaine des dispositifs microélectroniques intégrant des transistors de type différents sur un même support.

Elle concerne plus particulièrement un procédé amélioré pour former des zones de contact à base d'un composé à base de métal et de semi-conducteur pour de tels dispositifs.

Il est connu de vouloir réaliser un dispositif comprenant, sur un même substrat, des transistors de type N dont la région de canal est formée dans un premier matériau semi-conducteur choisi pour être bon conducteur d'électrons et des transistors de type P dont la région de canal est formée dans un deuxième matériau semi-conducteur mieux adapté à la conduction par trous.

Le document « III-V/Ge CMOS technologies on Si platform CMOS », de Takagi et al., Symposium on VLSI technology Digest of Technical Papers, 2010 présente par exemple un dispositif réalisé en technologie CMOS (acronyme de l'anglais «Complementary Metal Oxide Semiconductor») sur un substrat de type semi-conducteur sur isolant avec un transistor de type n-MOS dont le canal est en un matériau III-V et un de type p-MOS dont le canal est en Germanium, chacune des régions de canal reposant sur la couche isolante du substrat.

Le document WO 2015/057171 A1 décrit la formation et le recuit d'une couche binaire afin de produire une couche comprenant du Si, du Ge ou une combinaison de ces éléments du groupe IV. Cette couche binaire, après recuit, sert de couche intermédiaire de contact pour, par exemple, un transistor à mobilité d'électrons élevée (HEMT) à base de GaN, et permet d'effectuer un procédé consécutif compatible CMOS.

Le document US 2014/0307997 A1 décrit, dans le contexte des circuits intégrés photoniques (PIC), le transfert d'une couche semi-conductrice en matériau III-V sur un substrat, et la formation de contacts en NiGe sur le composant dans le matériau semi-conducteur transféré ainsi que sur le PIC à base de silicium. Ces contacts sont formés en effectuant un recuit d'une couche structurée en Ge et d'une couche superposée en Ni.

Les performances des dispositifs microélectroniques CMOS sont notamment étroitement liées à la réduction de la résistance des contacts électriques.

Pour permettre de limiter la résistance d'accès de certaines régions semi-conductrices du transistor notamment de ses régions de source et drain, il est courant de former des zones d'alliage de métal et semi-conducteur sur ces régions. Pour cela on met généralement en œuvre une réaction dite de « siliciuration » entre une couche métallique et une couche semi-conductrice. Le matériau de la couche métallique peut être choisi parmi des métaux et des alliages tels qu'un alliage à base de nickel.

Un type de procédé de siliciuration courant pour réaliser des contacts sur un substrat et de type communément appelé « salicide » prévoit, un nettoyage du substrat puis un dépôt d'une couche métallique sur toute la surface d'un substrat doté de régions semi-conductrices, puis d'effectuer un recuit thermique rapide permettant la formation d'un alliage entre le métal et le matériau semi-conducteur des régions. Enfin, on réalise une attaque sélective permettant le retrait du métal qui n'a pas réagi.

L'amélioration du procédé de siliciuration est un des points clés pour atteindre les caractéristiques exigées pour les futurs nœuds technologiques notamment liées à la réduction des échelles, à l'architecture et à l'intégration de nouveaux matériaux.

La réalisation des zones de contacts sur un dispositif doté de régions semi-conductrices différentes et tel qu'évoqué plus haut pose problème.

En effet, la morphologie (i.e. la rugosité, la taille de grain, la densité de grain) et/ou l'épaisseur critique (i.e. l'épaisseur à partir de laquelle la couche métallique est continue) seront différentes selon les matériaux employés et/ou la technique dépôt, ce qui entraîne des difficultés d'intégration.

Il se pose le problème de trouver un nouveau procédé de réalisation de zones de contacts pour un dispositif à transistor doté de zones semi-conductrices différentes sur un même support, et qui présentent de préférence une faible résistance de contact, tout en ayant un nombre d'étapes limité.

### EXPOSÉ DE L'INVENTION

La présente invention concerne un procédé de réalisation de zones de contacts pour un dispositif à transistors comprenant des étapes consistant à :
a) former une structure dotée d'au moins une couche en un composé à base de semi-conducteur et de métal sur une ou plusieurs première(s) régions semi-conductrice(s) d'un premier transistor de type N et sur une ou plusieurs deuxième(s) région(s) semi-conductrices d'un deuxième transistor de type P reposant sur un même substrat, les premières régions étant à base d'un matériau de type III-V tandis que les deuxièmes régions semi-conductrices sont à base d'un autre matériau différent du matériau III-V,
   le semi-conducteur du composé étant un dopant de type N du matériau III-V,
b) effectuer au moins un recuit thermique de la structure de sorte à former sur les premières régions semi-conductrices des premières zones de contact et sur les deuxièmes régions semi-conductrices des deuxièmes zones de contact à base de composé de semi-conducteur et de métal tout en effectuant un dopage du matériau III-V.

La ou les première(s) région(s) peuvent être déjà dopées lorsqu'on dépose le composé à l'étape a). Ainsi, lorsqu'on réalise le recuit thermique à l'étape b) on augmente le dopage N des première(s) région(s) semi-conductrice(s).

Autrement dit, on effectue un sur-dopage des première(s) région(s) semi-conductrice(s).

Les deuxièmes régions semi-conductrices peuvent être en particulier à base de Si, ou de Ge ou de SiGe. Le semi-conducteur du composé peut être en particulier du Si, ou du Ge, ou du SiGe. Dans ce cas, on effectue un sur-dopage des première(s) région(s) semi-conductrice(s) sans modifier modifier le dopage des deuxièmes régions semi-conductrice(s).

Avantageusement, les deuxièmes régions semi-conductrices et le composé sont à base du même semi-conducteur. Ainsi, lorsque les deuxièmes régions semi-conductrices sont par exemple en Germanium, le composé choisi est formé de Germanium et d'un matériau métallique tel par exemple du Nickel.

De préférence, lorsque les deuxième régions semi-conductrices sont à base de par exemple de Germanium, le composé est du TiGe₂, ou du CoGe₂ ou du NiGe.

Lorsque les deuxième régions semi-conductrices sont à base de Silicium, le composé est préférentiellement du TiSi₂, ou du NiSi, ou du CoSi₂.

Avantageusement, le composé est formé par pulvérisation. Un tel procédé permet de maîtriser précisément les proportions en semi-conducteur et en métal du composé.

Un tel procédé peut également permettre de s'affranchir d'étape d'épitaxie.

Par rapport à un procédé de réalisation d'un alliage de métal et de semi-conducteur de l'art antérieur dans lequel on forme une couche semi-conductrice par épitaxie dans un équipement, puis on forme une couche métallique par PVD dans un autre équipement, un tel procédé de pulvérisation peut permettre de réaliser un composé de semi-conducteur et de métal en une seule étape, ou bien en plusieurs étapes mais sans que celui-ci soit entre ces étapes sorti de l'équipement de dépôt et soumis à l'air ambiant dans lequel se trouve cet équipement.

Ainsi, selon une première possibilité de mise en œuvre du procédé de pulvérisation, le composé peut être formé par pulvérisation d'une première cible à base de matériau semi-conducteur et d'une deuxième cible à base de matériau métallique, la première cible et la deuxième cible étant disposées dans une même enceinte de dépôt ou dans un même équipement de dépôt.

Selon une première possibilité de mise en œuvre du procédé de pulvérisation, le composé est formé par pulvérisation d'une cible à base à la fois de matériau semi-conducteur et de matériau métallique.

Avantageusement, préalablement à l'étape a) on forme sur les premières régions semi-conductrices et sur les deuxièmes régions semi-conductrices une couche semi-conductrice, la couche à base du composé étant ensuite déposée à l'étape a) sur cette couche semi-conductrice. Cette couche semi-conductrice est prévue à base d'un semi-conducteur constituant un dopant de type N du matériau III-V.

Une telle couche semi-conductrice permet lors de l'étape b) de recuit thermique d'augmenter l'effet de sur-dopage des premières régions semi-conductrices du transistor de type N ou de permettre d'effectuer ce sur-dopage sans que la stœchiométrie du composé soit trop modifiée.

La couche semi-conductrice est avantageusement à base du même semi-conducteur que ledit semi-conducteur du composé.

De préférence, la couche de composé et la couche semi-conductrice sont formées dans une même enceinte de dépôt ou dans un même équipement de dépôt. On évite ainsi de soumettre la couche semi-conductrice à l'air ambiant.

La couche semi-conductrice peut être également réalisée par pulvérisation.

Les premières régions semi-conductrices peuvent être respectivement des régions de source et de drain du premier transistor.

Les deuxièmes régions semi-conductrices peuvent être également des régions de source et de drain du deuxième transistor.

Avantageusement, préalablement à l'étape a) on forme une couche de masquage sur le premier transistor et le deuxième transistor puis une première cavité et une deuxième cavité dans cette couche de masquage et dévoilant respectivement le premier transistor et le deuxième transistor.

Avec un tel agencement, on peut former le composé de semi-conducteur et de métal uniquement sur les régions de source et de drain des transistors sans avoir à réaliser un retrait sélectif.

Préalablement à la formation de la première cavité et de la deuxième cavité, on peut réaliser une première zone de protection sur une grille du premier transistor et une deuxième zone de protection sur une grille du deuxième transistor.

Dans ce cas, on évite de former le composé de semi-conducteur et de métal sur la grille ou de devoir effectuer une gravure pour supprimer un court-circuit entre la grille et les régions de source et de drain.

La première zone de protection et la deuxième zone de protection peuvent être réalisées par :
- formation dans la couche de masquage d'ouvertures dévoilant respectivement une grille du premier transistor et une grille du deuxième transistor,
- retrait d'une portion de la grille du premier et de la grille du deuxième transistor, de sorte à former des trous dans le prolongement des ouvertures,
- dépôt d'un matériau de protection dans les trous.

On peut ainsi créer des zones de protection sans que cela ne nécessite un alignement précis.

Après l'étape a), on peut effectuer un remplissage de la première cavité et/ou de la deuxième cavité à l'aide d'au moins un métal. On peut ainsi former des plots de métal qui seront en contact avec le composé de semi-conducteur et de métal.

Le recuit thermique effectué à l'étape b) peut être alors réalisé après ce remplissage.

Selon une possibilité de mise œuvre du procédé, préalablement au dépôt de la couche de composé, on peut effectuer une étape de nettoyage des première et deuxième régions semi-conductrices. Dans le cas où le dépôt d'une couche semi-conductrice précède celui de la couche de composé, on effectue cette étape préalablement au dépôt de cette couche semi-conductrice.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1L servent à illustrer un exemple de procédé de réalisation de zones de contacts sur des régions semi-conductrices de nature différentes et reposant sur un même substrat ;
- les figures 2A-2B illustrent une variante de réalisation du premier exemple de procédé.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « supérieure », « superficielle », « latérale » s'appliquent en considérant que la structure est orientée de la façon illustrée dans les figures.

### EXPOSÉ DÉTAILLÉ DE MODES DE RÉALISATION PARTICULIERS

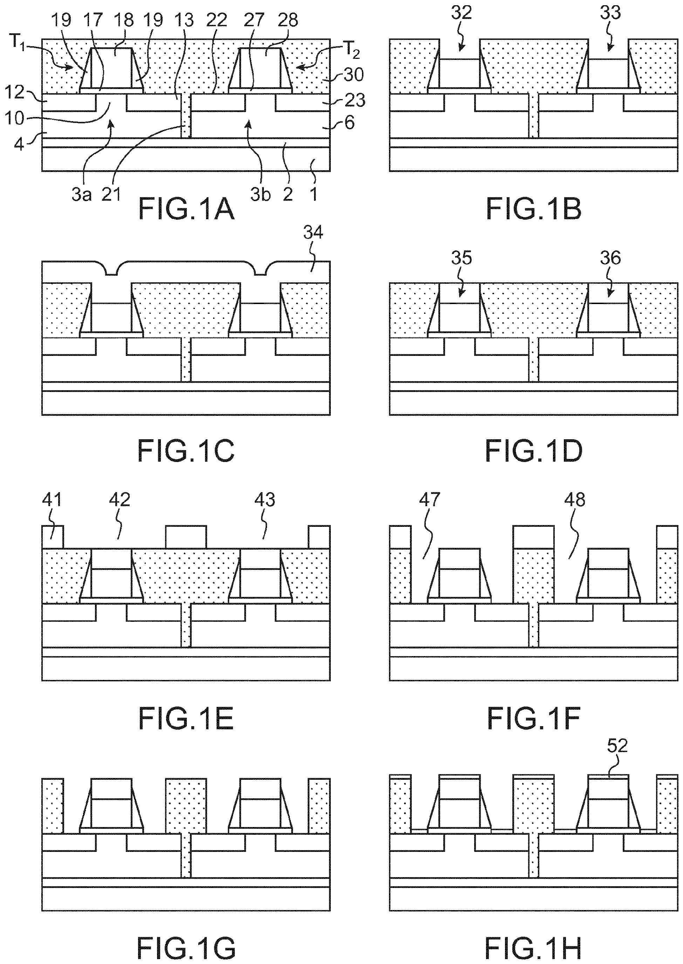

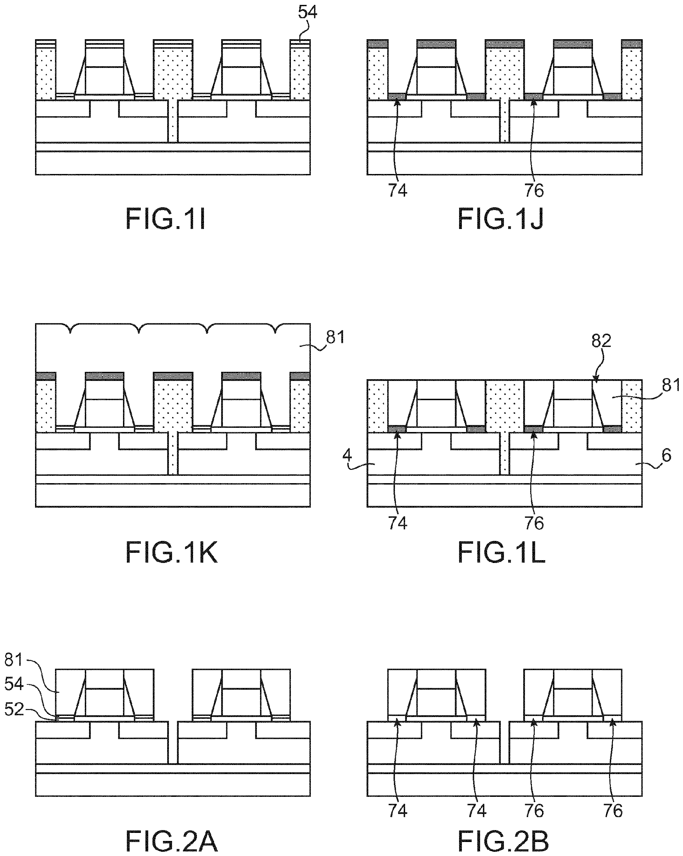

Un exemple de procédé de réalisation de zones de contacts à base d'un composé métallique de semi-conducteur et de métal pour des transistors de types différents va à présent être donné en liaison avec les figures 1A-1L.

On se réfère tout d'abord à la figure 1A sur laquelle un premier transistor T₁, et un deuxième transistor T₂ en cours de réalisation sont représentés.

Les transistors T₁, T₂ sont disposés sur un même substrat, qui peut être de type semi-conducteur sur isolant. Par substrat semi-conducteur sur isolant, on entend un substrat formé d'une couche de support 1 qui peut être semi-conductrice et est revêtue d'une couche isolante 2, par exemple un oxyde de silicium enterré, recouvrant la couche de support 1, elle-même revêtue d'au moins une couche semi-conductrice 3 superficielle.

La couche semi-conductrice 3 superficielle comprend quant à elle une première zone semi-conductrice 3a à base d'un premier matériau semi-conducteur 4 et une deuxième zone semi-conductrice 3b à base d'un deuxième matériau semi-conducteur 6, les première et deuxième zones 3a, 3b étant disposées sur et en contact de la couche isolante 2.

Le premier matériau semi-conducteur 4 est un matériau III-V par exemple à base de InGaAs, ou à base de InAs, ou de InGaSb ou de GaSb.

Le deuxième matériau semi-conducteur 6 est de préférence un matériau favorable à la conduction par trous et est à base de Ge ou de Si ou de SiGe, par exemple du p-Ge ou du p-Si ou du p-(SiGe). Ainsi, le premier transistor T₁ est un transistor de type N, en particulier NMOS tandis que le deuxième transistor T₂ est un transistor de type P, en particulier PMOS.

Le premier transistor T₁ comporte des régions semi-conductrices de source 12 et de drain 13 qui peuvent être sous forme respectivement de régions dopées N+ formées dans le premier matériau semi-conducteur 4, tandis que le deuxième transistor T₂ est doté de régions semi-conductrices 22 et 23 de source et de drain qui peuvent être dopées P+ et formées dans le deuxième matériau semi-conducteur 6.

Les transistors T₁, T₂ comportent chacun une région de canal 10 respectivement dans le premier matériau semi-conducteur 4 et dans le deuxième matériau semi-conducteur 6, chaque région de canal 10 étant surmontée d'une zone de diélectrique 17 de grille et d'une grille 18, 28. Des espaceurs isolants 19 peuvent être prévus contre des faces latérales des grilles, tandis que des zones d'isolation 21 de type STI (STI pour « shallow Trench Isolation » ou tranchées d'isolation peu profondes) peuvent être également formées entre les transistors T₁ et T₂, afin d'isoler électriquement ces derniers entre eux.

La figure 1A illustre une étape de réalisation d'une couche de masquage 30 déposée sur le substrat et recouvrant les transistors T₁ et T₂. Cette couche de masquage 30 peut être isolante et par exemple à base d'oxyde de silicium.

Ensuite, on forme des zones de protection 35, 36 sur les grilles des transistors T₁ et T₂. Pour cela, on peut réaliser tout d'abord des ouvertures 32, 33 dans la couche de masquage 30 dévoilant respectivement la grille du premier transistor T₁ et la grille du deuxième transistor T₂.

Avantageusement, on retire ensuite une portion des grilles 18, 28 au niveau de leur face supérieure. Ce retrait peut être effectué par gravure sélective du matériau de grille. La gravure sélective peut être réalisée par exemple à l'aide d'une gravure plasma à base de HBr lorsque le matériau de grille est par exemple du polysilicium
(figure 1B).

Les zones de protection 35, 36 peuvent être réalisées ensuite par dépôt d'une couche 34, par exemple à base de matériau diélectrique dans les ouvertures 32, 33 (figure 1C).

Lorsque la couche 34 est déposée sur la totalité de la plaque, on effectue ensuite un retrait de portions de la couche 34 qui dépassent de l'embouchure des ouvertures 32, 33. Un tel retrait peut être réalisé par exemple par CMP (polissage mécano-chimique) de sorte qu'à l'issue de la planarisation, la face supérieure des zones de protection 35, 36 et la face supérieure de la couche 34 de matériau diélectrique sont au même niveau (figure 1D).

On réalise ensuite des cavités dans la couche de masquage 30, afin de dévoiler au moins une partie des régions de source et de drain de part et d'autre des grilles de transistors.

Pour cela, on peut former tour d'abord un masque 41 par exemple en résine photosensible dans lequel on pratique des trous 42, 43 en regard respectivement du premier transistor T₁ et du deuxième transistor T₂ (figure 1E).

On prolonge ensuite ces trous 42, 43 pour former des cavités 47, 48 dans la couche de masquage 30 afin de créer des emplacements de contacts de source et de drain (figure 1F).

On retire ensuite le masque 41 de résine photosensible (figure 1G).

On réalise ainsi une structure dans laquelle, à l'exception des régions 12, 13 de source et de drain du premier transistor et 22, 23 du deuxième transistor dévoilées respectivement par la première cavité 47 et la deuxième cavité 48, le reste de la face supérieure du substrat est recouverte par la couche de masquage 30, les grilles respectives 18, 28 des transistors étant recouvertes par les zones de protection 35, 36.

Un nettoyage des régions de source et de drain peut alors être réalisé par exemple à l'aide d'un plasma ou d'un procédé humide ou d'une combinaison des deux afin notamment d'éviter de conserver un oxyde en surface de ces régions.

On effectue ensuite un dépôt d'une couche semi-conductrice 52 sur des parties des régions de source et de drain respectives du premier et du deuxième transistor qui sont dévoilées par les cavités 47, 48 (figure 1H). La couche semi-conductrice 52 est à base d'un semi-conducteur apte à constituer un dopant de type N du matériau III-V de régions. De préférence, la couche semi-conductrice 52 est à base d'un semi-conducteur qui n'est pas susceptible de modifier le dopage des régions de source et de drain du transistor de type P ou tout du moins d'altérer les propriétés électriques des régions de source et de drain du transistor de type P.

La couche semi-conductrice 52 peut être par exemple à base de Germanium. Ainsi, le semi-conducteur de la couche 52 peut être identique au deuxième matériau semi-conducteur 6 dans lequel la région de canal du deuxième transistor est prévue. La couche semi-conductrice 52 peut être ainsi prévue pour doper le matériau III-V sans que cela impacte les régions semi-conductrices 22, 23 à base du deuxième matériau semi-conducteur 6.

L'épaisseur de la couche semi-conductrice 52 peut être de l'ordre de plusieurs nanomètres, par exemple comprise entre 1 et 10 nm et avantageusement entre 2 et 5 nm.

Le matériau semi-conducteur de la couche semi-conductrice 52 peut être déposé sous forme amorphe, par exemple par CVD (pour « chemical vapor depostion ») ou par PVD (« physical vapor deposition »), ALD (« atomic layer deposition »), ou par dépôt humide électrochimique ou electroless. Le dépôt peut être assisté par un plasma.

Avantageusement, on réalise la couche semi-conductrice 52 par un procédé de pulvérisation (« sputtering » selon la terminologie anglo-saxonne) dans lequel on utilise par exemple une cible en Germanium. Avec un tel procédé, on peut s'affranchir d'une étape d'épitaxie.

Préalablement au dépôt de la couche semi-conductrice 52, on peut effectuer une étape de préparation de surface des parties dévoilées des régions de source et de drain. La préparation de surface peut être réalisée par exemple à l'aide d'une solution d'HCl diluée ou de HF/HCl diluée.

On peut avantageusement réaliser cette préparation de surface in situ c'est-à-dire dans la même machine de dépôt, en particulier dans une même enceinte que celle utilisée pour former le matériau semi-conducteur 52. Dans ce cas, un tel nettoyage peut être également réalisé par exemple à l'aide d'un plasma direct ou déporté à base d'Ar, ou de He, ou de NH₃, ou de H₂ ou d'un mélange de certains de ces gaz.

On effectue ensuite un dépôt d'une couche à base d'un composé métallique 54 à base de métal et de semi-conducteur sur la couche semi-conductrice 52 (figure 1I).

Ce composé 54 comprend un semi-conducteur apte à constituer un dopant de type N du matériau III-V des régions semi-conductrices 12 et 13. Le semi-conducteur à base duquel est formé le composé peut être choisi de sorte à ne pas modifier le dopage des régions de source et de drain du transistor de type P.

Le composé 54 est ainsi également choisi en fonction de la structure de bande du deuxième matériau semi-conducteur 6 de préférence de sorte à être un midgap par rapport au deuxième semi-conducteur 6, c'est-à-dire dont le niveau de Fermi coïncide avec le milieu de la bande interdite du matériau semi-conducteur 6.

Dans le cas, par exemple, où le premier matériau semi-conducteur 4 de type III-V est du InGaAs et où le deuxième matériau semi-conducteur 6 est du Ge, on peut choisir le composé 54 par exemple parmi les composés suivants : TiSi₂, TaSi₂, WSi₂ CoSi₂, NiSi₂, NiSi, Ni₂Si, CoSi₂, Ti(SiGe)₂ de structure C49, Ni(SiGe) de structure B31, Ta(SiGe)₂ de structure C40.

Avantageusement, le semi-conducteur de ce composé 54 est le même que celui à base duquel la couche semi-conductrice 52 est formée, par exemple du Germanium lorsque les régions de source 22, et de drain 23 du deuxième transistor T₂ sont à base de Germanium. Ainsi, dans le cas précité où les régions 12, 13 sont en InGaAs et où les régions 22, 23 sont en Ge, on peut choisir le composé 54 par exemple parmi: TaGe₂, WGe₂, TaGe₂, ou de préférence parmi les composés suivants : NiGe, TiGe₂, CoGe₂. De tels composés ont pour avantage de permettre de réaliser des zones de contact de plus faible résistivité. Ils sont également plus aisés à élaborer.

La couche réalisée du composé 54 peut avoir une épaisseur comprise par exemple entre 2 et 25 nm et préférentiellement comprise entre 5 nm et 15 nm.

Le composé 54 peut être déposé par exemple par CVD (pour « chemical vapor depostion ») ou par PVD (« physical vapor deposition ») ou par ALD (« atomic layer deposition »), par un procédé électrochimique ou électro-less. Le dépôt peut être éventuellement assisté d'un plasma.

Avantageusement, on réalise la couche de composé 54 par un procédé de pulvérisation (« sputtering » selon la terminologie anglo-saxonne) dans lequel on utilise une ou plusieurs cibles dont est ou sont extrait(s) l'élément ou les éléments à déposer. Le composé 54 est ici obtenu directement par dépôt sans qu'un recuit thermique soit nécessaire pour l'obtenir.

Un tel procédé de pulvérisation permet de contrôler aisément les proportions respectives de matériau métallique et semi-conducteur dans le composé 54

Par exemple, lorsque le composé 54 est à base de NiGe, on peut mettre en œuvre un composé avec une proportion de Ni de 50 % atomique et une proportion de Ge de 50 % atomique, ou réaliser du NiGe riche en Germanium c'est-à-dire avec une proportion de Ge comprise entre 50 et 90 % atomique.

Un tel procédé de pulvérisation peut éventuellement permettre de réaliser une couche de composé 54 comportant un gradient de concentration en matériau semi-conducteur. Par exemple, on peut mettre en œuvre une couche de Ni_{y}Ge_{1-y} avec y variant suivant la profondeur dans laquelle on se situe dans cette couche.

Le procédé de dépôt par pulvérisation peut être effectué en utilisant une première cible à base du matériau semi-conducteur, par exemple une cible de Germanium ainsi qu'une deuxième cible à base du matériau métallique, par exemple une cible de Nickel. La première cible et la deuxième cible sont alors disposées dans une même enceinte ou dans des enceintes différentes de dépôt d'un même équipement de dépôt. Avec un tel procédé de pulvérisation, les différents constituants du composé 54 peuvent être ainsi déposés sans que le substrat quitte l'équipement de dépôt dans lequel ce dépôt est réalisé.

En variante on utilise une seule cible à base du composé que l'on souhaite déposer, par exemple une cible de NiGe.

Avantageusement, on peut former la couche semi-conductrice 52 et le composé 54 par des étapes de pulvérisations successives réalisées dans un même équipement de dépôt voire dans une même enceinte de dépôt.

On évite ainsi de sortir le substrat de l'équipement de dépôt ce qui entraînerait une remise du matériau semi-conducteur de la couche 52 à l'air ambiant de la salle blanche dans laquelle se trouve l'équipement de dépôt et serait susceptible de provoquer une oxydation en surface de la couche semi-conductrice 52.

Par rapport à un procédé de siliciuration dans lequel on réaliserait un dépôt de semi-conducteur dans un équipement puis un dépôt de métal dans un autre équipement, on évite ainsi de créer un « air-break », qui pourrait éventuellement créer un oxyde et nécessiter de réaliser une étape de nettoyage préalablement au dépôt de métal.

Après le dépôt du composé 54, on effectue au moins un recuit thermique.

Un tel recuit permet d'homogénéiser le composé de métal et de semi-conducteur et lorsque celui-ci n'est pas sous forme cristalline, de le cristalliser.

Le recuit thermique permet en outre de réaliser un sur-dopage du matériau III-V des régions semi-conductrices 12, 13 de source et de drain du transistor T₁ de type N. Par « sur-dopage », on entend que l'on augmente le dopage des régions semi-conductrices 12, 13 déjà dopées.

On forme ainsi des zones de contact 74 à base de composé de semi-conducteur et de métal sur les régions semi-conductrices 12, 13 de source et de drain du premier transistor T₁. On forme concomitamment des zones de contact 76 à base du même composé de semi-conducteur et de métal sur les régions semi-conductrices 22, 23 de source et de drain du deuxième transistor T₂. Dans le cas où la couche 52 est en Ge et le composé 54 est du NiGe on forme des zones de contact 74, 76 en Ni_{y}Ge_{1-y}.

Le recuit thermique peut être un recuit rapide, i.e. d'une durée qui peut être comprise par exemple entre 10 et 600 s, préférentiellement entre 30 et 120 secondes à une température comprise entre 200 °C et 600 °C, de préférence entre 250 °C et 400 °C.

Le recuit est effectué de préférence sous atmosphère inerte.

Un procédé de recuit de type communément appelé « spike », ou de type RTP (pour « Rapid Thermal Process ») pour lesquels une rampe élevée de température est mise en œuvre peut être réalisé. En variante, on effectue ce recuit à l'aide d'un laser ou par énergie micro-onde.

Ainsi, avec un tel procédé on réalise avec un même recuit des contacts ohmiques 74, 76 sur les régions de source et de drain des transistors tout en effectuant le sur-dopage des régions de source et de drain du premier transistor.

Dans cet exemple de réalisation, les grilles 18, 28 respectives des transistors sont protégées par les zones protection 35, 36 si bien que le composé de semi-conducteur et de métal n'est pas formé sur les grilles.

Puis, on peut effectuer un dépôt de matériau métallique 81 de sorte à combler les cavités 47, 48 réalisées de part et d'autre des grilles de transistors T₁, T₂ et dévoilant les zones de contact (figure 1K).

On peut ensuite retirer des portions de matériau métallique dépassant de l'embouchure des trous. Un tel retrait peut être effectué par exemple par CMP en s'arrêtant au niveau des zones de protection 35, 36 disposées sur les grilles 18, 28 (figure 1L). On forme ainsi des plots 82 métalliques sur les contacts ohmiques en composé de métal et de semi-conducteur.

Avec un tel procédé tel que précédemment décrit un retrait sélectif n'est pas nécessaire dans la mesure où la formation du composé de métal et de semi-conducteur est localisée sur des portions de régions de source et de drain, grâce aux cavités 47, 48 formées dans la couche de masquage 30 par un procédé de type SAC pour « self aligned contact ».

Dans l'exemple de réalisation qui a été donné précédemment, le dépôt du composé 54 métallique à base de semi-conducteur et de métal est précédé de celui de la couche semi-conductrice 52 .

Selon une variante de réalisation, on effectue un dépôt du composé 54 à base de semi-conducteur et de métal directement sur les régions de source et de drain sans couche semi-conductrice intermédiaire. Dans ce cas, on adapte la stœchiométrie du composé 54 et sa proportion en semi-conducteur pour pouvoir conserver l'effet de sur-dopage au moment du recuit thermique. Dans le cas par exemple où le composé 54 est à base de NiₓGe₁₋ₓ on choisit de préférence x < 0.5.

Le composé 54 et la couche 52 sont adaptées en fonction de la composition de régions semi-conductrices de source et de drain.

Dans le cas, par exemple, où le premier matériau semi-conducteur 4 de type III-V est du InGaAs et où le deuxième matériau semi-conducteur 6 est du est Si, Ge ou du SiGe, on peut choisir le composé 54 par exemple parmi les composés suivants : Ti(SiGe)₂ de structure C49, Ni(SiGe) de structure B31, Ta(SiGe)₂ de structure C40.

Lorsque le premier matériau semi-conducteur 4 des régions de source et de drain du premier transistor est du InGaAs et le deuxième matériau semi-conducteur 6 des régions de source et de drain du deuxième transistor est du Si on peut également choisir le composé 54 parmi les composés suivants : TaGe₂, WGe₂, TiGe₂, NiGe, CoGe₂.

Avantageusement, le semi-conducteur à base duquel le composé 54 est formé est le même que celui de la couche semi-conductrice 52, par exemple du silicium lorsque les régions de source 22, et de drain 23 du deuxième transistor sont à base de silicium. Ainsi, dans le cas précité où les régions 12, 13 sont en InGaAs et où les régions 22, 23 sont en Si, on peut choisir le composé 54 par exemple parmi: TaSi₂, WSi₂ NiSi₂, Ni₂Si, ou de préférence parmi : TiSi₂, CoSi₂, NiSi.

Une variante de l'un ou l'autre des exemples de réalisation précédemment décrit prévoit de n'effectuer le recuit thermique d'homogénéisation du composé et de sur-dopage qu'après avoir effectué le remplissage des cavités 47, 48 par le métal 81 pour former les plots 82 métalliques sur les contacts ohmiques.

Ainsi, selon cette variante, on dépose la couche semi-conductrice 52 sur des parties dévoilées des régions de source et de drain, puis on forme la couche de composé 54 sur cette couche semi-conductrice 52. Ensuite, on dépose le métal 81 dans les cavités 46, 47, que l'on planarise pour former les plots 82 métalliques (figure 2A).

Puis, on effectue le recuit thermique de sorte à rendre homogène le composé, voire de le cristalliser, afin de former des contacts 74 sur les régions de source et de drain du premier transistor T₁ et des contacts 76 sur les régions de source et de drain du deuxième transistor T₂, tout en effectuant un sur-dopage des régions de source et de drain du premier transistor T₁.

Une autre variante de réalisation de l'un ou l'autre des procédés précédemment décrits prévoit de former une couche barrière de diffusion, par exemple à base de TiN préalablement au dépôt de métal 81. Une telle couche barrière peut avoir une épaisseur de l'ordre de plusieurs nanomètres par exemple comprise entre 2 et 20 nm.

Un procédé suivant l'invention s'adapte tout particulièrement à la réalisation de dispositifs à transistors réalisés selon des nœuds technologiques avancés et correspondant à par exemple à des dimensions de grille de l'ordre de plusieurs nanomètres, en particulier de 7 nm.

## Revendications

1. Procédé de réalisation de zones de contacts pour un dispositif à transistors comprenant des étapes consistant à :
a) former une structure dotée d'au moins une couche en un composé (54) à base de semi-conducteur et de métal sur une ou plusieurs première(s) régions semi-conductrice(s) (12, 13) d'un premier transistor (T₁) de type N et sur une ou plusieurs deuxième(s) région(s) semi-conductrices (22, 23) d'un deuxième transistor (T₂) de type P reposant sur un même substrat, les premières régions (12, 13) étant à base d'un matériau (4) de type III-V tandis que les deuxièmes régions semi-conductrices (22, 23) sont à base d'un autre matériau (6) différent du matériau III-V, cet autre matériau étant du Si, ou du Ge, ou du SiGe, le semi-conducteur du composé (54) étant choisi parmi le Si, le Ge, ou le SiGe de sorte à constituer un dopant de type N du matériau III-V,
b) effectuer au moins un recuit thermique de la structure de sorte à former sur les premières régions semi-conductrices (12, 13) des premières zones (74) de contact à base de composé de semi-conducteur et de métal et sur les deuxièmes régions semi-conductrices (22, 23) des deuxièmes zones (76) de contact à base de composé de semi-conducteur et de métal tout en réalisant un dopage N du matériau III-V ou en augmentant le dopage N du matériau III-V.

2. Procédé selon la revendication 1, dans lequel le composé (54) est formé par pulvérisation.

3. Procédé selon la revendication 2, dans lequel le composé (54) est formé par la pulvérisation d'une première cible à base du matériau semi-conducteur et d'une deuxième cible à base du matériau métallique, la première cible et la deuxième cible étant disposées dans une même enceinte de dépôt ou dans un même équipement de dépôt.

4. Procédé selon la revendication 2, dans lequel le composé (54) est formé par pulvérisation d'une cible à base d'un matériau semi-conducteur et d'un matériau métallique.

5. Procédé selon l'une des revendications 1 à 4, dans lequel, préalablement au dépôt de la couche dudit composé à l'étape a) on dépose une couche semi-conductrice (52) sur les premières régions semi-conductrices et sur les deuxièmes régions semi-conductrices, la couche à base du composé (54) étant déposée sur cette couche semi-conductrice (52), la couche semi-conductrice (52) étant à base d'un dopant de type N du matériau III-V, en particulier du même semi-conducteur que le semi-conducteur du composé (54).

6. Procédé selon la revendication 5, dans lequel le composé (54) et la couche semi-conductrice (52) sont formées dans une même enceinte de dépôt ou dans un même équipement de dépôt.

7. Procédé selon l'une des revendication 5 ou 6, dans lequel préalablement à la formation de la couche semi-conductrice (52) on réalise une étape de nettoyage.

8. Procédé selon l'une des revendications 1 à 7, dans lequel les premières régions semi-conductrice(s) (12, 13) sont des régions de source et de drain du premier transistor (T₁) dévoilées par une première cavité (47), les deuxièmes régions semi-conductrices (22, 23) sont des régions de source et de drain du deuxième transistor (T₂) dévoilées par une deuxième cavité (48), la première cavité et la deuxième cavité étant formées préalablement à l'étape a) dans une couche de masquage (30) réalisée sur le substrat et recouvrant les transistors.

9. Procédé selon la revendication 8, dans lequel préalablement à la formation de la première cavité et de la deuxième cavité, on réalise une première zone de protection (35) sur une grille (18) du premier transistor (T₁) et une deuxième zone de protection (36) sur une grille (28) du deuxième transistor (T₂).

10. Procédé selon la revendication 9, dans lequel la première zone de protection (35) et la deuxième zone de protection (36) sont réalisées par :
- formation dans la couche de masquage d'ouvertures dévoilant respectivement une grille du premier transistor et une grille du deuxième transistor,
- retrait d'une portion de la grille du premier et de la grille du deuxième transistor, de sorte à former des trous dans le prolongement des ouvertures,
- dépôt d'un matériau de protection dans les trous.

11. Procédé selon l'une des revendications 9 ou 10, comprenant en outre après l'étape a), le remplissage de la première cavité et/ou de la deuxième cavité à l'aide d'au moins un métal (81), de sorte à former des plots.

12. Procédé selon la revendication 11, dans lequel le recuit thermique effectué à l'étape b) est réalisé après ce remplissage.

13. Procédé selon l'une des revendications 1 à 12, dans lequel les deuxièmes régions semi-conductrices (22, 23) et le composé (54) sont à base du même semi-conducteur.

14. Procédé selon la revendication 13, dans lequel :
- les deuxièmes régions semi-conductrices (22, 23) sont à base de Germanium, le composé (54) étant à base de Germanium et préférentiellement du TiGe₂, ou du CoGe₂ ou du NiGe, ou
- les deuxièmes régions semi-conductrices (22, 23) sont à base de Silicium, le composé (54) étant à base de Silicium et préférentiellement du TiSi₂, ou du NiSi, ou du CoSi₂.

## Patentansprüche

1. Verfahren zur Realisierung von Kontaktzonen für eine Transistorvorrichtung, umfassend die folgenden Schritte:
a) Bilden einer Struktur, die mit wenigstens einer Schicht aus einer Verbindung (54) auf Basis von Halbleiter und von Metall versehen ist, auf einer oder mehreren erste(n) Halbleiterregion(en) (12, 13) eines ersten Transistors (T₁) vom Typ N und auf einer oder mehreren zweite(n) Halbleiterregion(en) (22, 23) eines zweiten Transistors (T₂) vom Typ P, die auf ein und demselben Substrat ruhen, wobei die ersten Regionen (12, 13) auf Basis eines Materials (4) vom Typ III-V sind, wohingegen die zweiten Halbleiterregionen (22, 23) auf Basis eines anderen Materials (6) sind, das von dem III-V-Material verschieden ist, wobei dieses andere Material Si oder Ge oder SiGe ist, wobei der Halbleiter der Verbindung (54) ausgewählt ist aus Si, Ge oder SiGe derart, dass er ein Dotierungsmittel vom Typ N des III-V-Materials bildet,
b) Durchführen wenigstens eines thermischen Glühens der Struktur derart, dass auf den ersten Halbleiterregionen (12, 13) erste Kontaktzonen (74) auf Basis einer Verbindung von Halbleiter und von Metall gebildet werden, und auf den zweiten Halbleiterregionen (22, 23) zweite Kontaktzonen (76) auf Basis einer Verbindung von Halbleiter und von Metall unter Realisierung einer N-Dotierung des III-V-Materials oder unter Erhöhung der N-Dotierung des III-V-Materials.

2. Verfahren nach Anspruch 1, bei dem die Verbindung (54) durch Pulverisierung gebildet wird.

3. Verfahren nach Anspruch 2, bei dem die Verbindung (54) gebildet wird durch die Pulverisierung eines ersten Targets auf Basis von Halbleitermaterial und eines zweiten Targets auf Basis von Metallmaterial, wobei das erste Target und das zweite Target in ein und demselben Abscheidungsbehälter oder in ein und demselben Abscheidungsgerät angeordnet sind.

4. Verfahren nach Anspruch 2, bei dem die Verbindung (54) gebildet wird durch Pulverisierung eines Targets auf Basis eines Halbleitermaterials und eines Metallmaterials.

5. Verfahren nach einem der Ansprüche 1 bis 4, bei dem man vor der Abscheidung der Schicht der Verbindung im Schritt a) eine Halbleiterschicht (52) auf den ersten Halbleiterregionen und auf den zweiten Halbleiterregionen abscheidet, wobei die Schicht auf Basis der Verbindung (54) auf dieser Halbleiterschicht (52) abgeschieden wird, wobei die Halbleiterschicht (52) auf Basis eine Dotierungsmittels vom Typ N des III-V-Materials ist, insbesondere des gleichen Halbleiters wie der Halbleiter der Verbindung (54).

6. Verfahren nach Anspruch 5, bei dem die Verbindung (54) und die Halbleiterschicht (52) in ein und demselben Abscheidungsbehälter oder in ein und demselben Abscheidungsgerät gebildet werden.

7. Verfahren nach einem der Ansprüche 5 oder 6, bei dem man vor der Bildung der Halbleiterschicht (52) einen Reinigungsschritt durchführt.

8. Verfahren nach einem der Ansprüche 1 bis 7, bei dem die ersten Halbleiterregionen (12, 13) Source- und Drainregionen des ersten Transistors (T₁) sind, aufgedeckt durch einen ersten Hohlraum (47), wobei die zweiten Halbleiterregionen (22, 23) Source- und Drainregionen des zweiten Transistors (T₂) sind, aufgedeckt durch einen zweiten Hohlraum (48), wobei der erste Hohlraum und der zweite Hohlraum vor dem Schritt a) in einer Maskierungsschicht (30) gebildet werden, die auf dem Substrat realisiert ist und die Transistoren bedeckt.

9. Verfahren nach Anspruch 8, bei dem man vor der Bildung des ersten Hohlraums und des zweiten Hohlraums eine erste Schutzzone (35) auf einem Gate (18) des ersten Transistors (T₁) und eine zweite Schutzzone (36) auf einem Gate (28) des zweiten Transistors (T₂) realisiert.

10. Verfahren nach Anspruch 9, bei dem die erste Schutzzone (35) und die zweite Schutzzone (36) realisiert werden durch:
- Bilden, in der Maskierungsschicht, von Öffnungen, die ein Gate des ersten Transistors beziehungsweise ein Gate des zweiten Transistors aufdecken,
- Entfernen eines Bereichs des Gates des ersten und des Gates des zweiten Transistors derart, dass Löcher in der Verlängerung der Öffnungen gebildet werden,
- Abscheiden eines Schutzmaterials in den Löchern.

11. Verfahren nach einem der Ansprüche 9 oder 10, ferner umfassend nach dem Schritt a) das Füllen des ersten Hohlraums und/oder des zweiten Hohlraums mit Hilfe wenigstens eines Metalls (81), derart, dass Punkte gebildet werden.

12. Verfahren nach Anspruch 11, bei dem das im Schritt b) durchgeführte thermische Glühen nach diesem Füllen realisiert wird.

13. Verfahren nach einem der Ansprüche 1 bis 12, bei dem die zweiten Halbleiterregionen (22, 23) und die Verbindung (54) auf Basis des gleichen Halbleiters sind.

14. Verfahren nach Anspruch 13, bei dem:
- die zweiten Halbleiterregionen (22, 23) auf Basis von Germanium sind, wobei die Verbindung (54) auf Basis von Germanium und vorzugsweise von TiGe₂ oder von CoGe₂ oder von NiGe ist, oder
- die zweiten Halbleiterregionen (22, 23) auf Basis von Silizium sind, wobei die Verbindung (54) auf Basis von Silizium und vorzugsweise von TiSi₂ oder NiSi oder von CoSi₂ ist.

## Claims

1. A Method of producing contact zones for a transistor device including the following steps:
a) forming a structure with at least one layer made of a compound based on semiconductor and metal on one or more first semiconductor region(s) of a first N-type transistor and on one or more second semiconductor region(s) of a second P-type transistor resting on a same substrate, the first regions being based on a III-V type material whereas the second semiconductor regions are based on another material different from the III-V material, wherein said other material is Si, or Ge, or SiGe, the semiconductor of the compound being chosen from Si, Ge, or SiGe so as to constitute an N-type dopant of the III-V material.
b) carrying out at least one thermal annealing of said structure so as to form on the first semiconductor regions first contact zones based on a semiconductor and metal compound and on the second semiconductor regions second contact zones based on a semiconductor and metal compound while carrying out an N-doping of the III-V material or by increasing the N-doping of the III-V material.

2. The method according to claim 1, wherein the compound (54) is formed by sputtering.

3. The method according to claim 2, wherein the compound (54) is formed by the sputtering of a first target based on the semiconductor material and of a second target based on the metal material, the first target and the second target being arranged in a same deposition enclosure or in a same deposition equipment.

4. The method according to claim 2, wherein the compound is formed by sputtering of a target based on a semiconductor material and a metal material.

5. The method according to any of the claims 1 to 4, wherein, prior to the deposition of the layer of said compound at step a) a semiconductor layer (52) is deposited on the first semiconductor regions and on the second semiconductor regions, the layer based on the compound (54) being deposited on this semiconductor layer (52), the semiconductor layer being based on an N-type dopant of the III-V material, in particular the same semiconductor as the semiconductor of the compound (54).

6. The method according to claim 5, wherein the compound (54) and the semiconductor layer (52) are formed in a same deposition enclosure or in a same deposition equipment.

7. The method according to any of the claims 5 or 6, wherein prior to the formation of the semiconductor layer (52) a step of cleaning is carried out.

8. The method according to any of the claims 1 to 7, wherein the first semiconductor regions (12, 13) are source and drain regions of the first transistor (T₁) exposed by a first cavity (47), the second semiconductor regions (22, 23) are source and drain regions of the second transistor (T₂) exposed by a second cavity (48), the first cavity and the second cavity being formed beforehand at step a) in a masking layer (30) produced on the substrate and covering the transistors.

9. The method according to claim 8, wherein prior to the formation of the first cavity and the second cavity, a first protection zone (35) is produced on a gate (18) of the first transistor (T₁) and a second protection zone is produced on a gate of the second transistor (T₂).

10. The method according to claim 9, wherein the first protection zone (35) and the second protection zone (36) are produced by:
- formation in the masking layer of openings exposing respectively a gate of the first transistor and a gate of the second transistor,
- removal of a portion of the gate of the first and the gate of the second transistor, so as to form holes in the extension of the openings,
- deposition of a protective material in the holes.

11. The method according to any of the claims 9 or 10, further including after step a), the filling of the first cavity and/or the second cavity using at least one metal (81), so as to form pads.

12. The method according to claim 11, wherein the thermal annealing carried out at step b) is carried out after this filling.

13. The method according to any of the claims 1 to 12, wherein the second semiconductor regions (22, 23) and the compound (54) are based on the same semiconductor.

14. The method according to claim 13, wherein:
- the second semiconductor regions (22, 23) are based on germanium, the compound (54) being based on germanium and preferentially TiGe₂, or CoGe₂ or NiGe, or
- the second semiconductor regions (22, 23) are based on silicon, the compound (54) being based on silicon and preferentially TiSi₂, or NiSi, or CoSi₂.
